# EUROPÄISCHE PATENTSCHRIFT

(11) **EP 2 514 282 B1**
(45) Veröffentlichungstag und Bekanntmachung des Hinweises auf die Patenterteilung: **20.09.2017**
(21) Anmeldenummer: 10784955.6
(22) Anmeldetag: 15.10.2010
(51) Int. Cl.: H05K 1/02, H05K 1/03

(54) **LEITERPLATTE MIT MEHREREN ÜBEREINANDER ANGEORDNETEN LEITERPLATTENLAGEN MIT EINER BARE-DIE-MONTAGE FÜR DEN EINSATZ ALS GETRIEBESTEUERUNG**
MULTILAYER PRINTED CIRCUIT BOARD HAVING A BARE-DIE-MOUNTING FOR USE IN A GEAR BOX CONTROL
CIRCUIT ÉLECTRIQUE COMPRENANT UN PANNEAU À CIRCUIT MULTICOUCHE À MONTAGE DE PUCE NUE POUR COMMANDE DES BOÎTES DE VITESSES

(30) Priorität: 17.12.2009 DE 102009058914; 17.12.2009 DE 102009058915
(43) Veröffentlichungstag der Anmeldung: 24.10.2012
(73) Patentinhaber: Conti Temic Microelectronic GmbH, 90411 Nürnberg (DE)
(72) Erfinder: SAUERBIER, Jürgen, 91462 Dachsbach (DE); GRÜBL, Wolfgang, 90610 Winkelhaid (DE); SCHUCH, Bernhard, 91616 Neusitz (DE); TRAGESER, Hubert, 91338 Igensdorf (DE); ROBIN, Hermann-Josef, 93053 Regensburg (DE)
(74) Vertreter: Bonn, Roman Klemens
(86) Internationale Anmeldenummer: PCT/DE2010/001209
(87) Internationale Veröffentlichungsnummer: WO 2011/072629

(56) Entgegenhaltungen:
- EP-A2- 0 559 607
- DE-A1- 4 303 824
- JP-A- 10 117 052
- JP-A- H07 321 471
- JP-A- 2004 140 063
- US-A- 4 335 180
- US-A1- 2005 151 240

## Beschreibung

Leiterplatte mit mehreren übereinander angeordneten Leiterplattenlagen mit einer Bare-Die-Montage für den Einsatz als Getriebesteuerung

Die Erfindung betrifft eine Leiterplatte mit mehreren übereinander angeordneten Leiterplattenlagen.

Aus dem Stand der Technik ist es allgemein bekannt, dass in der Kraftfahrzeugtechnik Komponenten wie Getriebe-, Motoren-oder Bremssysteme zunehmend elektronisch gesteuert sind. Hierzu existieren integrierte mechatronische Steuerungen, auch als Vorort-Elektroniken bezeichnet, welche durch Integration von Steuerelektronik und zugehöriger elektronischer Komponenten wie Sensoren oder Ventile in das Getriebe, den Motor oder das Bremssystem erzeugbar sind. Das heißt, die Steuerelektronik und die zugehörigen elektronischen Komponenten sind nicht in einem separaten geschützten Elektronikraum außerhalb des Getriebes, Motors oder Bremssystems untergebracht. Um die Steuerelektronik und die zugehörigen elektronischen Komponenten vor Umwelteinflüssen und mechanischen, thermischen sowie chemischen Beanspruchungen zu schützen, sind diese in spezielle Gehäuse eingesetzt, welche zusätzlich eine wichtige Abschirmfunktion erfüllen.

Der übliche Aufbau für solche integrierten mechatronischen Steuerungen besteht aus einem keramischen Substrat, welches die verschiedenen elektronischen Bauteile einer zentralen Steuereinheit beinhaltet. Um eine Anbindung peripherer Komponenten an die zentrale Steuereinheit zu ermöglichen, ist das keramische Substrat mittels Bondverbindungen, wie Aluminium-Dickdrahtbondverbindungen, mit starren oder flexiblen Leiterplatten oder Stanzgittern verbunden. Weiterhin wird der gesamte Elektronikraum mit dem bestückten Schaltungsträger zum Schutz der Bondverbindungen, der Leiterzüge und Bauteile vor Feuchtigkeit und anderen Umwelteinflüssen mit einem Silikon-Gel überzogen.

Bei der Anwendung einer integrierten mechatronischen Steuerung als Getriebesteuerungsmodul ist dieses im Getriebeölsumpf untergebracht und daher vollständig mit Öl und darin enthaltenen elektrisch leitfähigen Kontaminationen umgeben. Dies sind Kontaminationen aus Verzahnungsabrieb, Zerspanungsresten aus Fertigungsprozessen und/oder unzulänglichen Wasch- und Reinigungsprozessen des Getriebegehäuses und/oder der verbauten Komponenten. Zum notwendigen Schutz vor solcher Kontamination, vor Beschädigungen und Leiterbahn- oder Bondkurzschlüssen wird eine Verdeckelung als metallischer, nicht-metallischer oder metallisierter Gehäusedeckel auf eine Gehäusebodenplatte des Getriebesteuerungsmoduls aufgebracht und hermetisch abgedichtet.

Zur Realisierung derartiger Einheiten zur Getriebesteuerung werden vorwiegend ungehäuste Halbleiter-Bauteile eingesetzt, die mittels Leitklebetechnik auf dem keramischen Substrat als Schaltungsträger montiert und über Drahtbondtechniken mittels Gold- und Aluminiumdraht elektrisch zum Schaltungsträger hin kontaktiert werden. Die keramischen Schaltungsträger sind als so genannte Dickschichtschaltungen oder als Niedertemperatur-Einbrand-Keramik (englisch: Low Temperature Cofired Ceramics = LTCC) ausgebildet. Bei beiden keramischen Schaltungsträger-technologien werden Leiterbahnen durch hoch-silberhaltige Pasten im Siebdruckverfahren dargestellt. Zusätzlich können durch nachfolgende so genannte "Plating"-Prozesse mittels einer Schichtabfolge aus z. B. Nickel, Palladium und Gold auf den Leiterbahnen des Schaltungsträgers multifunktionale Endoberflächen realisiert werden, welche gleichzeitig für Verbindungstechniken wie Löttechniken, Silberleitkleben, Drahtbonden mit Gold- oder Aluminium-Draht geeignet sind. Diese beiden keramischen Schaltungsträger-Technologien sind für hohe Einsatztemperaturen im oder am Getriebe geeignet.

Zu.einer Wärmeableitung oder so genannten Entwärmung der Schaltung sind die keramischen Schaltungsträger mittels Wärmeleitkleber auf metallische Grundplatten oder Gehäuseteile geklebt.

Die US 2005/0151240 A1 beschreibt ein Radiofreqenzmodul mit einer Keramik-Mehrlagenleiterplatte aus dielektrischen Lagen und leitfähigen Lagen. Die von einem Leistungshalbleiter produzierte Wärme wird teilweise von der Oberfläche des Moduls abgeleitet und teilweise durch eine Leiterstruktur, auf der der Leistungshalbleiter angeordnet ist, und dann durch die Leiterplattenlagen oder Durchkontaktierungen bis zur untersten Lage des Moduls horizontal und vertikal abgeleitet.

Weiterhin existieren technische Lösungen, welche anstatt des keramischen Substrats eine Leiterplatte umfassen.

Eine Montage der ungehäusten Halbleiterbauteile auf der Leiterplatte mittels Silberleitkleben und Drahtbonden wird auch als Chip-on-Board (= COB) bezeichnet. Die Halbleiterbauteile werden dabei mit einem singulären, auf die Bauteile einzeln aufgetragenen so genannten "Glop top" gegenüber Umwelteinflüssen wie Feuchtigkeit geschützt. Das Glob-top-Material ist ein polymeres Harz, typischerweise Epoxidharz mit Füllstoffen wie Siliziumoxid, welches in seiner thermischen Ausdehnung an die thermische Ausdehnung der Leiterplatte angepasst ist, wobei das Glob-top-Material einen hohen Elastizitäts-Modul besitzt. Chip-on-Board-Anwendungen sind für moderate Zuverlässigkeits- und Temperaturanforderungen, beispielsweise zwischen -40°C und 85°C, ausgelegt. Getriebesteuerungen weisen dagegen einen typischen Einsatztemperaturbereich von -40°C bis +160°C und höheren Temperaturen auf. Für derartige Einsatztemperaturbereiche sind keine Anwendungen bekannt.

Aus dem Stand der Technik ist ferner bekannt, dass eine Wärmeableitung von den Bauteilen über so genannte thermische Vias erfolgt. Bei der Montage von ungehäusten Halbleiterkomponenten, auch als "Bare dies" bezeichnet, auf einen Leiterplatten-Schaltungsträger werden die als ungehäuste Halbleiterkomponenten ausgebildeten Bauelemente zusammen mit passiven Komponenten leitfähig auf die Oberfläche der Leiterplatte geklebt oder gelötet. Eine elektrische Kontaktierung zwischen dem Bauelement und dem Schaltungsträger erfolgt mittels Bonddrahtverbindungen. Um eine Verlustwärme der Bauelemente, insbesondere aktiver Bauelemente, abzuleiten, sind bei einer Standard-Leiterplattentechnik, einer so genannten Multilayertechnik, als thermische Vias bezeichnete und mechanisch gebohrte Durchkontaktierungen eingesetzt. Der Einsatz thermischer Vias erfolgt sowohl für gehäuste als auch für ungehäuste Komponenten. Der Wärmefluss erfolgt dabei über die thermischen Vias zur Unterseite der Leiterplatte. Ein an der Leiterplatten-Unterseite angeordnetes Kupfer-Pad überträgt die Wärme über den Wärmeleitkleber zu einem Kühlkörper.

Die DE 43 03 824 A1 und die EP 0559 607 A2 beschreiben ein Epoxidharzsysteme zur Herstellung von Leiterplatten verwendet, wobei die Systeme Glasübergangstemperaturen > 160°C aufweisen.

Die JP 2004140063 A beschreibt eine Mehrlagenleiterplatte aus Leiterbahnlagen und Glas-Epoxy-Lagen, wobei mittels thermischer Vias zwischen oberster und unterster Leiterlattenlage die von einem elektronischen Bauteil produzierte Wärme an die Umgebung abgeleitet wird.

Die DE 10 2007 032 535 A1 beschreibt ein elektronisches Modul mit einem Gehäusedeckel und mindestens einer mehrlagigen Leiterplatte als elektrische Verbindung zwischen dem Gehäuseinnenraum und außerhalb des Gehäuses liegenden Komponenten. Die mehrlagige Leiterplatte ist Schaltungsträger für elektronische Bauteile einer zentralen Steuerungselektronik und gleichzeitig thermische Anbindung an eine Bodenplatte für eine integrierte mechatronische Getriebesteuerung. Die Leiterplatte weist Vias zur thermischen Anbindung an die Bodenplatte und zur elektronischen Anbindung an die außerhalb des Gehäuses liegenden Komponenten auf.

Bei den integrierten Getriebesteuerungen, aber auch bei der Ausführung der Steuereinheit als Anbausteuergerät, sind Temperatur- und Vibrationsbelastungen auf die elektronischen Bauteile auf den Schaltungsträgern und Verbindungsstellen zwischen den elektronischen Bauteilen und den Leiterbahnen auf dem Schaltungsträger oder zwischen den elektronischen Bauteilen selbst sehr groß. Somit ist eine Anpassung der Leiterplatte an Anforderungen der Steuereinheiten zur Getriebesteuerung erforderlich.

Der Erfindung liegt die Aufgabe zugrunde, eine gegenüber dem Stand der Technik verbesserte Leiterplatte mit mehreren übereinander angeordneten Leiterplattenlagen anzugeben, welche verbesserte funktionale Eigenschaften aufweist und gleichzeitig mit geringem Aufwand und wirtschaftlich herstellbar ist. Insbesondere soll die Leiterplatte Anforderungen an hohe Temperaturen, chemische und mechanische Beanspruchungen insbesondere bei Fahrzeuganwendungen besser erfüllen als die aus dem Stand der Technik bekannten Lösungen. Der Erfindung liegt weiterhin die Aufgabe zugrunde, eine gegenüber dem Stand der Technik verbesserte Steuereinheit für Fahrzeuganwendungen und eine Verwendung der Steuereinheit anzugeben.

Hinsichtlich der Leiterplatte wird die Aufgabe erfindungsgemäß durch im Anspruch 1 angegebenen Merkmale, hinsichtlich der Steuereinheit durch die im Anspruch 12 angegebenen Merkmale und hinsichtlich der Verwendung der Steuereinheit durch die im Anspruch 13 angegebenen Merkmale gelöst.

Vorteilhafte Ausgestaltungen der Erfindung sind Gegenstand der Unteransprüche.

Eine Leiterplatte umfasst mehrere übereinander angeordnete Leiterplattenlagen.

Erfindungsgemäß sind die Leiterplattenlagen jeweils aus einem Basismaterial gebildet, dessen Glasübergangstemperatur größer oder gleich 170°C ist, und die Leiterplattenlagen weisen jeweils wenigstens eine auf das elektrisch isolierende Basismaterial aufgebrachte Wärmeleitschicht auf, wobei mehrere in einer z-Richtung senkrecht zu den Leiterplattenlagen verlaufende Vias vorgesehen sind, die die Wärmeleitschichten verschiedener Leiterplattenlagen derart verbinden, dass die Vias und die Wärmeleitschichten der Leiterplattenlagen eine Wärmeleitbrücke von einer obersten Leiterplattenlage zu einer untersten Leiterplattenlage bilden. Die Wärmeleitschichten dienen dabei gleichzeitig als elektrischer Leiter.

Insbesondere handelt es sich bei der Leiterplatte um eine HDI-Leiterplatte (HDI = High Density Interconnect) mit einer so genannten Bare-Die-Montage für den Einsatz als Getriebesteuerung für ein Fahrzeug.

Mit Via (= Vertical Interconnect Access), auch Lagenwechsler genannt, wird eine vertikale Durchkontaktierung bezeichnet, die wenigstens zwei Leiterplattenlagen einer mehrlagigen Leiterplatte verbindet.

Vias, die als durchkontaktierte Löcher mit einem Durchmesser kleiner als etwa 150 *µ*m ausgebildet sind, werden auch als Mikrovias bezeichnet.

Als Blind Via wird ein Via bezeichnet, das als Sackloch mit einer Durchkontaktierung ausgebildet ist, die die oberste oder unterste Leiterplattenlage mit wenigstens einer inneren Leiterplattenlage einer mehrlagigen Leiterplatte verbindet.

Als Buried Via wird ein Via bezeichnet, das im Inneren einer mehrlagigen Leiterplatte angeordnet ist und wenigstens zwei innere Leiterplattenlagen verbindet.

Vias, die primär einer Verbesserung des Wärmetransportes durch eine Leiterplatte dienen, werden auch als thermische Vias bezeichnet.

Thermische Vias werden insbesondere zur Entwärmung von Leiterplatten eingesetzt, auf denen Wärme abgebende aktive elektrische Bauteile, beispielsweise ungehäuste Halbleiterbauteile, angeordnet sind.

Da die Vias dabei als thermische Vias wirken, über die Wärme durch die verschiedenen Leiterplattenlagen abgeleitet werden kann, resultiert aus der erfindungsgemäßen Ausbildung der Leiterplatte in vorteilhafter Weise, dass diese für hohe Einsatztemperaturen ausgelegt ist und sich für integrierte mechatronische Anwendungen eignet.

Gemäß einer besonders vorteilhaften Ausgestaltung der erfindungsgemäßen Leiterplatte ist das Basismaterial glasfaserverstärkter Kunststoff, welcher Keramikpartikel umfasst. Diese Basismaterialien sind einfach und kostengünstig verfügbar. Eine Vereinheitlichung von Schaltungsträgeraufbauten ist prinzipiell möglich und zusätzlich können größere Schaltungsträgergeometrien realisiert werden oder aber auch sehr spezielle Formen mit Abrundungen, Ecken und anderen Formen erzeugt werden.

Vorzugsweise ist eine Gesamtoberfläche aller Wärmeleitschichten wenigstens einer Leiterplattenlage größer als eine Gesamtoberfläche aller Wärmeleitschichten einer darüber liegenden Leiterplattenlage. Die von den Vias und Wärmeleitschichten gebildete Wärmeleitbrücke wird dabei von wenigstens einer Leiterplattenlage zu einer darunter liegenden Leiterplattenlage verbreitert, da die Gesamtoberfläche aller Wärmeleitschichten wenigstens einer Leiterplattenlage größer als eine Gesamtoberfläche aller Wärmeleitschichten einer darüber liegenden Leiterplattenlage ist. Dadurch wird die für den Wärmetransport wirksame Fläche vorteilhaft vergrößert und der Wärmewiderstand der Leiterplatte reduziert, da der Wärmewiderstand wenigstens näherungsweise proportional zum Kehrwert der für den Wärmetransport wirksamen Fläche ist.

Eine besonders bevorzugte Ausgestaltung der Leiterplatte sieht alternativ oder zusätzlich vor, dass die Größe der zu der z-Richtung senkrechten Oberflächen der Wärmeleitschichten von der obersten Leiterplattenlage zu der untersten Leiterplattenlage monoton zunimmt.

Dabei wird unter einer monotonen Zunahme der Größe dieser Oberflächen verstanden, dass die Größe der Oberflächen von einer Leiterplattenlage zu einer direkt darunter liegenden Leiterplattenlage jeweils zunimmt oder gleich bleibt, jedoch nicht abnimmt.

Dadurch kann die für den Wärmetransport wirksame Fläche in z-Richtung von oben nach unten sukzessive vergrößert werden. Insbesondere lassen sich auf diese Weise auch sehr kleine aktive elektrische Bauteile effizient entwärmen.

Dies ist besonders vorteilhaft für die Entwärmung von kompakt gestalteten Leiterplatten mit entsprechend kleinen elektrischen Bauteilen, insbesondere so genannten HDI-Leiterplatten (HDI = High Density Interconnect), da direkt unterhalb kleiner elektrischer Bauteile nur relativ wenige Vias angeordnet werden können und somit die erfindungsgemäße Vergrößerung der für den Wärmetransport wirksamen Fläche besonders wirkungsvoll ist.

In einer bevorzugten Ausgestaltung der Erfindung sind einige Vias erste Blind Vias, die wenigstens eine Wärmeleitschicht der obersten Leiterplattenlage mit wenigstens einer Wärmeleitschicht einer darunter liegenden Leiterplattenlage verbinden. Dadurch wird vorteilhaft ein Wärmekontakt von der obersten Leiterplattenlage zu einer darunter liegenden Leiterplattenlage hergestellt. Insbesondere können die ersten Blind Vias als Mikrovias ausgeführt sein, was besonders vorteilhaft für HDI-Leiterplatten ist.

Ferner sind einige Vias vorzugsweise zweite Blind Vias, die wenigstens eine Wärmeleitschicht der untersten Leiterplattenlage mit wenigstens einer Wärmeleitschicht einer darüber liegenden Leiterplattenlage verbinden. Dies ermöglicht eine Wärmeleitung aus dem Inneren der Leiterplatte zu der untersten Leiterplattenlage, über die die Wärme nach außen abgeleitet werden kann. Auch die zweiten Blind Vias können als Mikrovias ausgeführt sein, wiederum besonders vorteilhaft im Falle von HDI-Leiterplatten.

Weiterhin sind einige Vias bevorzugt Buried Vias, die jeweils Wärmeleitschichten wenigstens zweier verschiedener Leiterplattenlagen verbinden. Dadurch kann die Wärme vorteilhaft durch das Innere der Leiterplatte geleitet werden, wobei die Anordnung, Größe und Ausgestaltung der Buried Vias der Leiterplattengeometrie angepasst werden kann.

Vorzugsweise sind die ersten Blind Vias und/oder die zweiten Blind Vias und/oder die Buried Vias Mikrovias, so dass möglichst viele Vias auf einer kleinen Fläche anordbar sind.

Wenigstens ein Via ist dabei vorzugsweise hülsenartig ausgebildet. Darunter wird verstanden, dass es als hüllenartiger Hohlkörper ausgebildet ist. Eine hülsenartige Ausbildung von Vias reduziert vorteilhaft das Gewicht der Leiterplatte und verringert den zu ihrer Herstellung nötigen Materialaufwand und entsprechend die Materialkosten.

Gemäß einer vorteilhaften Weiterbildung der Erfindung sind in die Leiterplattenlagen in z-Richtung senkrecht zu den Leiterplattenlagen Aussparungen mit einem Durchmesser in einem Bereich zwischen 100 *µ*m und 150 *µ*m zur Aufnahme der ersten Blind Vias und/oder zweiten Blind Vias und Aussparungen mit einem Durchmesser von mindestens 250 *µ*m zur Aufnahme der Buried Vias eingebracht. Somit handelt es sich bei der Leiterplatte um eine Leiterplatte mit einer so genannten High-Density-Interconnect-Technik (= HDI-Technik). Mehrlagige HDI-Leiterplatten zeichnen sich gegenüber Standard-Leiterplatten dadurch aus, dass sie einen geringeren Bohrlochdurchmesser zur Aufnahme der Vias aufweisen. Somit ist eine höhere Anzahl an Vias pro Fläche möglich. Daraus resultiert neben einer erhöhten Stromtragfähigkeit insbesondere eine verbesserte Wärmeableitung.

Gemäß einer vorteilhaften Weiterbildung sind die Wärmeleitschichten der Leiterplattenlagen und/oder Wände der Vias aus Kupfer gefertigt. Daraus ergibt sich, dass sich die erfindungsgemäße Leiterplatte durch eine erhöhte Stromtragfähigkeit gegenüber Keramiksubstraten mit als Pasten in einem Druckverfahren aufgebrachten elektrischen Leitern auszeichnet.

Insbesondere ist die Leiterplatte für Getriebesteuerungen verwendbar, wobei die Leiterplatte hierzu in eine Steuereinheit bzw. ein Steuergerät integriert ist. Dabei sind aufgrund der hohen Stromtragfähigkeit der Leiterplatte Ansteuerungen für Pumpen oder Motoren mit erhöhten Strömen im Bereich von 15 A bis 50 A und höher realisierbar.

Gegenüber aus dem Stand der Technik bekannten Lösungen, bei welchen die Leiterstrukturen zur Realisierung einer derartigen Stromtragfähigkeit auf die keramischen Schaltungsträger in sehr aufwändiger Weise durch Spezialsubstrate, insbesondere in einem so genannten "Direct-Copper-Bonding-Verfahren", erzeugbar sind, weisen die Leiterplatten aufgrund der aus Kupfer gebildeten Wärmeleitschichten und/oder Leiterbahnen eine besonders hohe Stromtragfähigkeit aus. Die Wärmeleitschichten sind in besonders einfacher Weise aus Kupfer und in verschiedenen Schichtdicken erzeugbar, so dass diese besonders einfach an die erforderliche Verwendung und die erforderliche Stromtragfähigkeit anpassbar sind. Dabei sind beispielsweise Kupferschichtdicken von 35 *µ*m und 70 *µ*m, aber auch größere Kupferschichtdicken im Bereich 200 *µ*m bis 400 *µ*m erzeugbar und verfügbar. Aufgrund dieser Ausbildung der Leiterplatten sind sehr viel höhere Stromtragfähigkeiten gegenüber keramischen Schaltungsträgern realisierbar, wobei Stromtragfähigkeiten bis in den Bereich von 100 A und mehr möglich sind. Weiterhin werden aufgrund der Ausbildung der Wärmeleitschichten der Leiterplattenlagen und/oder Wände der Vias aus Kupfer die guten Wärmeleitungseigenschaften von Kupfer zur Entwärmung der Leiterplatte genutzt.

In vorteilhafter Weise ist zusätzlich auf die Wärmeleitschichten der Leiterplattenlagen und/oder die Wände der Vias eine multifunktionale Zusatzmetallisierung mit einer Schichtabfolge aus z. B. Nickel, Palladium und Gold aufgebracht. Dadurch ist eine Bestückung der Leiterplatte mit ungehäusten Halbleiterbauteilen zusammen mit passiven Bauteilen, d. h. eine so genannte Bare-die-Bestückung, möglich. Hierzu ist die Zusatzmetallisierung auf die äußere Kupfer-Oberfläche der Wärmeleitschichten und/oder der Wände der Vias aufgebracht, wobei die Zusatzmetallisierung gleichzeitig für Montageprozesse mittels Löttechnik, Silberleitkleben und Verbindungstechniken, wie z. B. Drahtbonden mit Gold-Draht und/oder Aluminium-Draht, geeignet ist.

Durch die beschriebene Optimierung des Herstellungsprozesses der Leiterplatte und die Zusatzmetallisierung der Leiterplattenaußenlagen sind hohe Zuverlässigkeitswerte, vor allem für die Gold- und/oder Aluminium-Drahtbondverbindungen, erzielbar.

Die Leiterplatte kann insbesondere wenigstens ein auf der obersten Leiterplattenlage angeordnetes aktives elektrisches Bauteil und/oder wenigstens ein auf der obersten Leiterplattenlage angeordnetes passives elektrisches Bauteil aufweisen. Dadurch kann die von den Vias und den Wärmeleitschichten gebildete Wärmeleitbrücke vorteilhaft zum Ableiten von Wärme verwendet werden, die von dem wenigstens einen elektrischen Bauteil abgegeben wird.

Hierbei ist bevorzugt eine zweite Wärmeleitkleberschicht vorgesehen, die das wenigstens eine aktive elektrische Bauteil stoffschlüssig mit der obersten Leiterplattenlage verbindet, so dass das wenigstens eine aktive elektrische Bauteil und/oder passive elektrische Bauteil in einfacher Weise Wärme leitend auf der obersten Leiterplattenlage fixiert.

Ferner weist die oberste Leiterplattenlage bevorzugt eine dem wenigstens einen elektrischen Bauteil zugewandte Wärmeleitschicht auf, deren Oberfläche größer ist als eine ihr zugewandte Oberfläche des wenigstens einen aktiven elektrischen Bauteils. Somit weist die oberste Leiterplattenlage eine an dem wenigstens einen aktiven elektrischen Bauteil anliegende Wärmeleitschicht auf, mittels derer von dem wenigstens einen elektrischen Bauteil abgegebene Wärme aufgenommen werden kann. Außerdem ist diese Wärmeleitschicht gegenüber der ihr zugewandten Oberfläche des wenigstens einen elektrischen Bauteils vergrößert, wodurch von dem wenigstens einen elektrischen Bauteil abgegebene Wärme auf eine größere Oberfläche dieser Wärmeleitschicht verteilt wird und die Wärmekapazität der obersten Leiterplattenlage vorteilhaft vergrößert wird.

Gemäß einer besonders bevorzugten Weiterbildung sind ein Kühlkörper, der unter der untersten Leiterplattenlage angeordnet ist, und eine erste Wärmeleitkleberschicht vorgesehen, die den Kühlkörper stoffschlüssig mit der untersten Leiterplattenlage verbindet.

Um die Wärme besonders effizient von der Leiterplatte ableiten zu können, muss die Dicke der ersten Wärmeleitkleberschicht möglichst gering sein, insbesondere kleiner als 100 *µ*m. Derartige Schichtdicken über die ganze Fläche der Leiterplatte sind nur zu realisieren, wenn die Durchbiegung der Leiterplatte kleiner ist als Dicke der Wärmeleitkleberschicht. Dies wird mit einem gezielten Lagenaufbau und Layoutoptimierungen, wie z. B. eine gleichmäßige Kupferverteilung in allen Ebenen, erreicht.

Der Kühlkörper kann beispielsweise als Wärmeleitplatte ausgebildet sein, z. B. als aus Aluminium gefertigte Wärmeleitplatte. Mittels der ersten Wärmeleitkleberschicht wird der Kühlkörper in einfacher Weise Wärme leitend an der untersten Leiterplattenlage fixiert.

In einer zweckmäßigen Weiterbildung ist die Leiterplatte auf einer dem Kühlkörper abgewandten Seite vollständig von einem Vergussmaterial umgeben und das zumindest eine elektrische Bauteil ist vollständig innerhalb des Vergussmaterials angeordnet. Daraus resultiert der Vorteil, dass der gesamte Schaltungsträger vor äußeren mechanischen, thermischen und chemischen Einflüssen geschützt ist. Insbesondere ist das Vergussmaterial ein Silikon-Gel und/oder Silikon-Lack, so dass ein so genannter weicher Verguss entsteht. Ein derartiger weicher Verguss zeichnet sich durch eine hohe thermische Ausdehnung bei gleichzeitig geringem Elastizitäts-Modul aus und ist somit zum Schutz des Schaltungsträgers auch bei hohen Temperaturen geeignet.

Weiterhin weisen Leiterbahnen vorzugsweise eine Leiterbahnbreite von mindestens 100 *µ*m und/oder Dielektrikaschichten eine Schichtdicke von mindestens 50 *µ*m auf, um besonders gute elektrische, thermische und mechanische Eigenschaften des Schaltungsträgers zu erzielen. Insbesondere sind durch gezielte Anpassung des prinzipiellen Leiterplatten-Lagenaufbaus, der Dimensionierung der Leiterbahnbreiten und der Leiterbahnabstände, der Dimensionierung der Dielektrika-Schichtdicken zwischen den Kupferlagen und der Auswahl der Lochdurchmesser der Vias Zuverlässigkeits- und Lebensdaueranforderungen der Leiterplatte erfüllbar.

Zusammenfassend sind die Leiterplatte und die Steuereinheit derart optimiert, dass insbesondere der Aufbau der Leiterplattenlagen, die Auswahl des Leiterplattenmaterials und die Kombination der Vias in den einzelnen Lagen derart gewählt wird, dass der Wärmeabtransport von den Bauteilen durch die Leiteplatte zum Kühlkörper bzw. zu einer Trägerplatte besonders effektiv ist und die Funktion der Leiterplatte auch bei hohen Außentemperaturen sichergestellt ist. Für den Einsatz in integrierten Getriebesteuerungen und in Anbau-Getriebesteuergeräten werden sehr hohe und zum Teil sehr spezifische Anforderungen an die Leiterplatte als Schaltungsträger selbst, aber auch an die Bestückung des Schaltungsträgers mit ungehäusten Komponenten gestellt.

Bei diesen Anforderungen handelt es sich, wie bereits beschrieben, um Einsatztemperaturen von mehr als 170°C für sehr lange Betriebszeiten, hohe thermomechanische Belastungen und Zyklenbelastungen für den Schaltungsträger, die Bauteile und die Verbindungsstellen. Weiterhin existieren sehr hohe Zuverlässigkeitsanforderungen für die Verbindungsstellen zwischen den elektrischen Bauteilen und der Leiterplatte, vor allem bei der Verwendung von Bondverbindungen. Auch dürfen die vorhandenen Öldämpfe keinen Einfluss auf den Betrieb der Steuereinheit und die darin befindliche Leiterplatte mit den elektrischen Komponenten haben und diese muss resistent gegenüber hochfrequenten Vibrationen sein sowie mit elektrischen Strömen von bis zu 100 A oder mehr belastbar sein.

Diese Anforderungen werden mittels der erfindungsgemäßen Lösung und deren Ausgestaltungen erfüllt.

Ausführungsbeispiele der Erfindung werden im Folgenden anhand von Zeichnungen näher erläutert.

Dabei zeigen:
- FIG 1: schematisch eine Schnittdarstellung einer erfindungsgemäßen Steuereinheit zur Verwendung als integrierte mechatronische Getriebesteuerung,
- FIG 2: schematisch eine Detaildarstellung eines Ausschnitts der Steuereinheit gemäß Figur 1,
- FIG 3: schematisch eine perspektivische Darstellung eines Kupfer-Skeletts einer mehrlagigen Leiterplatte mit einem aktiven elektrischen Bauteil und mehreren Vias,
- FIG 4: schematisch ausschnittsweise einen Längsschnitt durch die in Figur 3 dargestellte Leiterplatte, und
- FIG 5: schematisch eine perspektivische Darstellung eines Ausschnitts des in Figur 3 dargestellten Skeletts der Leiterplatte mit einem ersten und einem zweiten Blind Via und Abschnitten von vier Buried Vias.

Einander entsprechende Teile sind in allen Figuren mit den gleichen Bezugszeichen versehen.

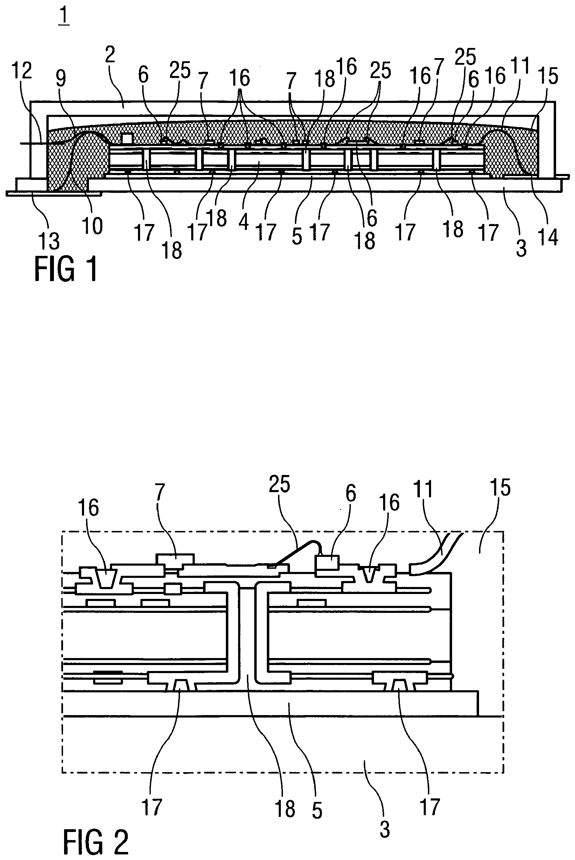

Die Figuren 1 und 2 zeigen eine erfindungsgemäße Steuereinheit 1 zur Verwendung als integrierte mechatronische Getriebesteuerung für ein nicht gezeigtes Fahrzeug in einer Schnittdarstellung und einer Detaildarstellung eines Ausschnitts der Steuereinheit 1.

Diese so genannte Vorort-Elektronik ist durch Integration von Steuerelektronik und zugehöriger elektronischer Komponenten, wie z. B. Sensoren oder Ventile in das Getriebe, erzeugbar. Dabei befinden sich die Steuerelektronik und die zugehörigen elektronischen Komponenten nicht in einem separaten geschützten Elektronikraum außerhalb des Getriebes. Um die Steuerelektronik und die zugehörigen elektronischen Komponenten vor Umwelteinflüssen und mechanischen, thermischen sowie chemischen Beanspruchungen zu schützen, sind diese in ein Gehäuse 2 eingesetzt, welches zusätzlich eine Abschirmfunktion erfüllt. Zusätzlich ist ein Kühlkörper 3 zur Abführung einer während des Betriebs der Steuereinheit 1 entstehenden Verlustwärme vorgesehen.

Die Steuerelektronik und die zugehörigen elektronischen Komponenten umfassen eine mehrlagige Leiterplatte 4, welche als HDI-Leiterplatte ausgebildet ist. Die mehrlagige Leiterplatte 4 umfasst mehrere nicht explizit dargestellte, in z-Richtung gestapelte Leiterplattenlagen und ist mittels einer ersten Wärmeleitkleberschicht 5 thermisch mit dem Kühlkörper 3 gekoppelt und an diesem befestigt. Die maximale Durchbiegung der Leiterplatte 4 ist dabei kleiner als die Schichtdicke der ersten Wärmeleitkleberschicht 5.

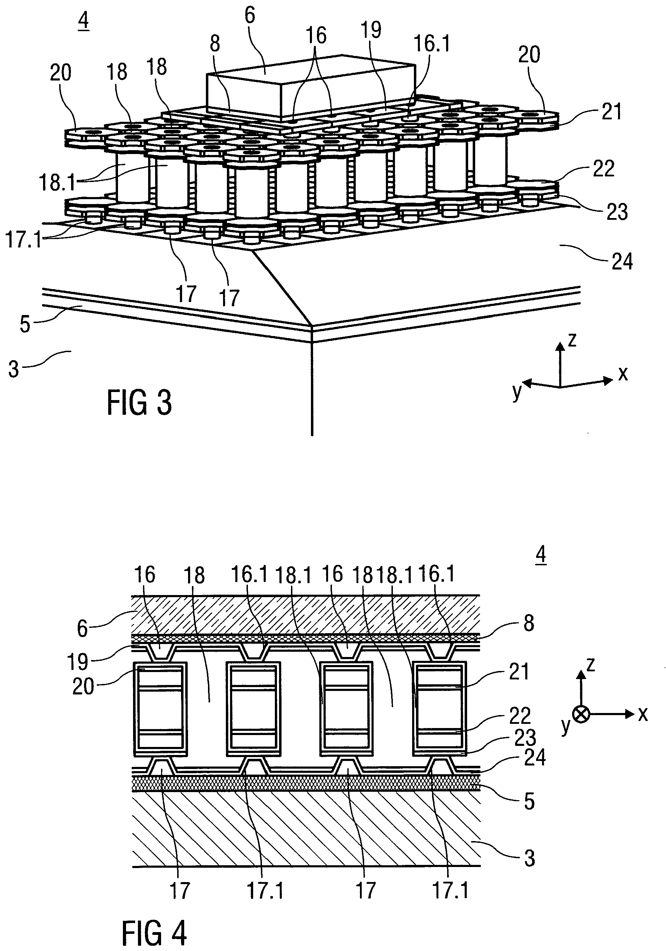

Auf einer obersten Lage der Leiterplatte 4 sind als Halbleiter ausgebildete aktive elektrische Bauteile 6 und als Halbleiter ausgebildete passive elektrische Bauteile 7 angeordnet, welche mittels einer in den Figuren 3 bis 5 näher dargestellten zweiten Wärmeleitkleberschicht 8 an der obersten Lage der Leiterplatte 4 befestigt sind.

Zur elektrischen Kontaktierung der Steuereinheit 1, insbesondere um eine Anbindung peripherer Komponenten an die Steuereinheit zu ermöglichen, ist die Leiterplatte 4 mittels Bonddrähten 9 bis 11 mit einem Stanzgitter 12 und flexiblen Leiterfolien 13, 14 verbunden. Die Bonddrähte 9 bis 11 sind dabei als Aluminium- oder Golddrahtbondverbindungen, insbesondere Dickdrahtbonverbindungen, ausgebildet.

Zum Schutz der Steuerelektronik und der zugehörigen elektronischen Komponenten sowie der Bondverbindungen vor mechanischen, chemischen und thermischen Einflüssen sind diese innerhalb des Gehäuses 2 vollständig von einem elektrisch isolierenden Vergussmaterial 15 umgeben, wobei das Vergussmaterial 15 als weicher Verguss aus Silikon-Gel gebildet ist, welcher sich durch eine hohe thermische Ausdehnung bei gleichzeitig geringem Elastizitäts-Modul auszeichnet und somit zum Schutz der Komponenten der Steuereinheit 1 auch bei hohen Temperaturen geeignet ist. Durch die Verwendung des Vergussmaterials 15 ist es weiterhin möglich, ungehäuste elektrische Bauteile 6, 7 zu verwenden.

Insbesondere wird durch die Vergussmasse eine hohe Stabilität aller elektrischer Verbindungen, eine Resistenz der Komponenten gegen Öldämpfe und gegen hochfrequente Schwingungen und Stöße realisiert.

Zur thermischen und elektrischen Kopplung der obersten Leiterplattenlage mit den inneren Leiterplattenlagen sind erste Blind Vias 16 und der untersten Leiterplattenlage mit den inneren Leiterplattenlagen zweite Blind Vias 17 vorgesehen, welche als Sackloch mit einer Durchkontaktierung ausgebildet sind.

Zur thermischen und elektrischen Kopplung der inneren Leiterplattenlagen sind Buried Vias 18 vorgesehen.

Sowohl die Blind Vias 16, 17 als auch die Buried Vias 18 dienen einer Verbesserung des Wärmetransports durch die Leiterplatte 4, insbesondere zur Entwärmung der Leiterplatte 4 aufgrund der Wärme abgebenden aktiven elektrischen Bauteile 6.

Um eine Wärmeleitung zwischen den einzelnen Leiterplattenlagen zu erzeugen, weist jede Leiterplattenlage jeweils eine Wärmeleitschicht 19 bis 24 auf. Die Wärmeleitschichten 19 bis 24 sind in Figur 4 näher dargestellt. Zur Wärmeleitung sind die Wärmeleitschichten 19 bis 24 verschiedener Leiterplattenlagen derart mittels der Blind Vias 16, 17 und der Buried Vias 18 miteinander verbunden, dass die Blind Vias 16, 17 und die Buried Vias 18 sowie die Wärmeleitschichten 19 bis 24 eine Wärmeleitbrücke von der obersten Leiterplattenlage zur untersten Leiterplattenlage bilden.

Die Blind Vias 16, 17 und Buried Vias 18 dienen der Verbesserung der vertikalen Wärmeleitung. In nicht dargestellter Weise können zusätzlich zur Wärmeableitung auch metallische Inlays, bevorzugt Kupfer-Inlays, verwendet werden.

Zur Verringerung einer Leitungs-Induktivität und/oder zur Erhöhung der Stromtragfähigkeit sind für eine Verbindung parallel mehrere Blind Vias 16, 17 und Buried Vias 18 in die Leiterplatte 4 eingebracht.

Mittels der Blind Vias 16, 17 und Buried Vias 18 ist es möglich, die Leiterbahnebenen in der mehrlagigen Leiterplatte 4 zu wechseln. Dies ist insbesondere hinsichtlich einer guten Entflechtung komplexer Schaltungen von großem Vorteil.

Die Blind Vias 16, 17 weisen einen Durchmesser zwischen 100 *µ*m und 150 *µ*m, die Buried Vias 18 von mindestens 250 *µ*m auf. Zumindest bei den Blind Vias 16, 17 handelt es sich somit um so genannte Mikrovias, welche vorzugsweise mittels eines Lasers erzeugt werden.

Aufgrund der hohen Dichte der Anordnung der Blind Vias 16, 17 und Buried Vias 18 ist die Leiterplatte 4 eine so genannte HDI-Leiterplatte (HDI = High-Density-Interconnect).

Im dargestellten Ausführungsbeispiel weist die mehrlagige Leiterplatte 4 jeweils eine äußere Leiterplattenlage mit den Blind Vias 16, 17, d. h. jeweils eine so genannte Mikrovialage auf. Zwischen den Mikrovialagen sind im Kernbereich der Leiterplatte 4 mehrere Zwischenlagen, bevorzugt vier oder sechs Zwischenlagen, angeordnet, welche thermisch mittels der Buried Vias 18 verbunden sind.

Um eine Funktion der Steuereinheit 1 auch bei im Getriebe des Fahrzeugs auftretenden hohen Temperaturen von mehr als 170°C sicherzustellen, sind die Leiterplattenlagen jeweils aus einem Basismaterial gebildet, dessen Glasübergangstemperatur größer oder gleich 170°C ist.

Das Basismaterial ist elektrisch isolierend und die Wärmeleitschichten 19 bis 24 sind auf das Basismaterial aufgebracht. Bei dem Basismaterial handelt es sich um glasfaserverstärkten Kunststoff, welchem Keramikpartikel beigemengt sind. Das Basismaterial zeichnet sich weiterhin durch eine extrem gute Zyklenbeständigkeit von mehr als 2000 Zyklen zwischen -40°C und +150°C und eine sehr niedrige thermische Ausdehnung aus. Um eine thermische Ausdehnung in z-Richtung von 30 ppm/K bis 40 ppm/K zu erreichen, sind dem Basismaterial Füllstoffe, insbesondere Keramikpartikel, beigemengt. Das Basismaterial inklusive der zugehörigen Wärmeleitschicht 19 bis 24 weist eine Schichtdicke von mindestens 50 *µ*m auf. Die erzeugten Leiterbahnen weisen Leiterbahnbreiten von mindestens 100 *µ*m auf.

Die Wärmeleitschichten 19 bis 24 und in den Figuren 3 bis 5 näher dargestellten Wände 16.1, 17.1, 18.1 der Blind Vias 16, 17 und Buried Vias 18 sind aus Kupfer gebildet oder mit einer Schicht aus Kupfer überzogen.

Um weiterhin eine Bestückung der Leiterplatte 4 mit ungehäusten aktiven Bauteilen, d. h. den aktiven elektrischen Bauteilen 6 zusammen mit den passiven elektrischen Bauteilen 7, zu ermöglichen, ist auf die äußere Kupfer-Oberfläche der Wärmeleitschichten 19 bis 24 in nicht näher dargestellter Weise eine Zusatzmetallisierung aufgebracht. Zur Erzeugung dieser Zusatzmetallisierung werden z. B. in einem Stromlosprozess in einer Schichtabfolge z. B. Nickel, Palladium und Gold nacheinander aufgebracht. Durch diese Zusatz- oder Endmetallisierung werden die Montageprozesse für ungehäuste elektrische Bauteile, insbesondere Löten oder Silberleitkleben, auf die Leiterplatte 4 und die Prozesse zur elektrischen Kontaktierung der elektrischen Bauteile 6, 7 mit der Leiterplatte, vorzugsweise Drahtbondtechniken und/oder Flipchiptechniken für Löten, besonders zuverlässig bzw. erst möglich. Das Drahtbonden erfolgt insbesondere mit Gold-und/oder Aluminium-Draht.

Vorzugsweise werden in der Steuereinheit 1 ausschließlich ungehäuste aktive und passive elektrische Bauteile 6 verwendet. Gehäuste Bauteile, die zur mechanischen und elektrischen Kontaktierung mit der Leiterplatte 4 auf diese gelötet werden, werden nicht verwendet, da diese aufgrund des Gehäuses eine schlechte Ableitung der vom Bauteil produzierten Wärme aufweisen. Die ungehäusten aktiven elektrische Bauteile 6 werden zur mechanischen Kontaktierung mittels der zweiten Wärmeleitkleberschicht 8, welche insbesondere aus Silberleitkleber gebildet ist, auf die oberste Leiterplattenlage aufgeklebt. Der elektrische Kontakt zur Leiterplatte 4 wird mittels Bonddrähten 25 hergestellt.

Figur 3 zeigt eine perspektivische Darstellung eines Kupfer-Skeletts der Leiterplatte 4 mit sechs übereinander angeordneten Leiterplattenlagen, einem auf einer obersten Leiterplattenlage angeordneten aktiven elektrischen Bauteil 6 und mehreren Vias 16, 17, 18. Die Leiterplatte 4 ist, wie bereits erläutert, eine HDI-Leiterplatte.

Die Leiterplattenlagen weisen jeweils eine plane Wärmeleitschicht 19 bis 24 auf. Die Wärmeleitschichten 19 bis 24 sind in zueinander parallelen und zur z-Richtung senkrechten Ebenen angeordnet, jeweils auf das elektrisch isolierende Basismaterial aufgebracht und aus Kupfer gefertigt.

Das elektrisch isolierende Basismaterial der Leiterplattenlagen ist jeweils glasfaserverstärkter Epoxidharz mit eingebrachten Keramikpartikeln, wobei das jeweils verwendete glasfaserverstärkte Epoxidharz von der Leiterplattenlage abhängen kann. Dadurch kann das verwendete Epoxidharz vorteilhaft an die Position der jeweiligen Leiterplattenlage innerhalb der Leiterplatte und/oder an deren Verwendung angepasst werden.

Das elektrisch isolierende Basismaterial füllt den Raum zwischen den Wärmeleitschichten 19 bis 24 und den Vias 16, 17, 18 und ist in Figur 3 nicht dargestellt; deshalb wird der in Figur 3 dargestellte Teil der Leiterplatte 4 als ihr Kupfer-Skelett bezeichnet.

Das aktive elektrische Bauteil 6 ist insbesondere ein ungehäuster Halbleiterchip, der im Betrieb Wärme abgibt. Das aktive elektrische Bauteil 6 ist mittels der zweiten Wärmeleitkleberschicht 8, beispielsweise einer Silberleitkleberschicht, stoffschlüssig mit der obersten Leiterplattenlage verbunden.

Unter der untersten Leiterplattenlage ist der Kühlkörper 3 angeordnet, der als eine Wärmeleitplatte aus Aluminium zur Aufnahme von Wärme aus der Leiterplatte 4 ausgebildet ist. Der Kühlkörper 3 ist mittels der ersten

Wärmeleitkleberschicht 5 stoffschlüssig mit der untersten Leiterplattenlage verbunden. Die erste Wärmeleitkleberschicht 5 kann beispielsweise als mit Keramikpartikeln gefüllter Silikonklebstoff ausgeführt sein.

Figur 4 zeigt ausschnittsweise einen Längsschnitt durch die in Figur 3 dargestellte Leiterplatte 4.

Die oberste Leiterplattenlage weist oberseitig eine einer Unterseite des aktiven elektrischen Bauteils 6 zugewandte erste Wärmeleitschicht 19 auf, deren Oberfläche größer als die Oberfläche der Unterseite des aktiven elektrischen Bauteils 6 ist. Die erste Wärmeleitschicht 19 ist der Übersichtlichkeit halber segmentiert dargestellt, wobei jedes Segment quadratisch ist und ein als Mikrovia ausgebildetes erstes Blind Via 16 aufweist, das unterhalb des aktiven elektrischen Bauteils 6 angeordnet ist.

Die ersten Blind Vias 16 sind Sacklöcher durch die erste Wärmeleitschicht 19 zur zweiten Wärmeleitschicht 20 der zweiten Leiterplattenlage, die unter der obersten Leiterplattenlage angeordnet ist. Jedes erste Blind Via 16 ist rotationssymmetrisch um die z-Richtung ausgebildet und verengt sich leicht konisch zu der zweiten Wärmeleitschicht 20 hin. Die Wände 16.1 der ersten Blind Vias 16 sind aus Kupfer gefertigt und verbinden die erste Wärmeleitschicht 19 mit der zweiten Wärmeleitschicht 20. Die ersten Blind Vias 16 haben im dargestellten Ausführungsbeispiel an ihrem oberen Ende jeweils einen Durchmesser von etwa 150 *µ*m und sind beispielsweise in Abständen von etwa 500 *µ*m angeordnet.

Die Oberfläche der zweiten Wärmeleitschicht 20 ist dabei größer als die Oberfläche der ersten Wärmeleitschicht 19, beispielsweise etwa doppelt so groß. Unter der zweiten Wärmeleitschicht 20 ist eine dritte Wärmeleitschicht 21 angeordnet, darunter eine vierte Wärmeleitschicht 22 und darunter eine fünfte Wärmeleitschicht 23, die jeweils zu einer dritten, vierten und fünften Leiterplattenlage gehören. Die Oberflächen der zweiten, dritten, vierten und fünften Wärmeleitschicht 20 bis 23 sind in diesem Ausführungsbeispiel jeweils gleich groß, können in anderen Ausführungsbeispielen jedoch von oben nach unten auch zunehmen.

Von der zweiten Wärmeleitschicht 20 bis zur fünften Wärmeleitschicht 23 erstrecken sich mehrere Buried Vias 18. Die Buried Vias 18 sind als zylinderförmige Hohlkörper mit Wänden 18.1 aus Kupfer ausgebildet, die jeweils die zweite, dritte, vierte und fünfte Wärmeleitschicht 20 bis 23 miteinander verbinden. Sie weisen insbesondere einen Durchmesser von etwa 250 *µ*m auf.

Unterhalb der fünften Wärmeleitschicht 23 ist die unterste Leiterplattenlage angeordnet, die unterseitig eine dem Kühlkörper 3 zugewandte sechste Wärmeleitschicht 24 aufweist. Die sechste Wärmeleitschicht 24 ist über die zweiten Blind Vias 17 mit der fünften Wärmeleitschicht 23 verbunden. Dabei sind die zweiten Blind Vias 17 analog zu den ersten Blind Vias 16 ausgebildet, nämlich als Sacklöcher durch die sechste Wärmeleitschicht 24 zu der fünften Wärmeleitschicht 23 mit Wänden 17.1 aus Kupfer, die die sechste Wärmeleitschicht 24 mit der fünften Wärmeleitschicht 23 verbinden.

Die Oberfläche der sechsten Wärmeleitschicht 24 ist größer als die Oberfläche der fünften Wärmeleitschicht 23, beispielsweise zwei- bis dreimal so groß. Die ihr zugewandte Oberfläche des Kühlkörpers 3 ist mindestens ebenso groß wie die Oberfläche der sechsten Wärmeleitschicht 24.

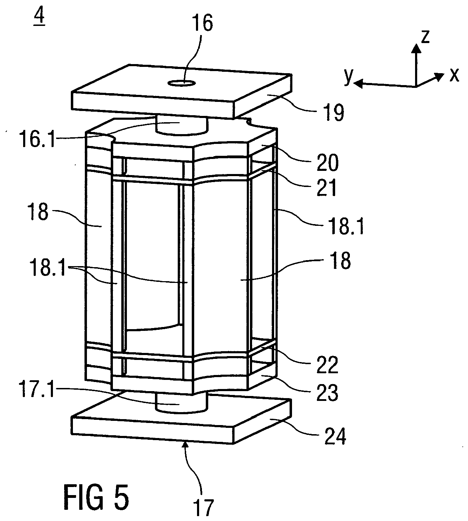

Figur 5 zeigt eine perspektivische Darstellung eines Ausschnitts des in Figur 3 dargestellten Skeletts der Leiterplatte 4 mit dem ersten Blind Via 16, dem zweiten Blind Via 17 und Abschnitten von vier Buried Vias 18. Figur 5 zeigt insbesondere, dass die Buried Vias 18 in x- und y-Richtung versetzt zu den ersten und zweiten Blind Vias 16, 17 angeordnet sind.

Durch die beschriebene gezielte Optimierung der Leiterplattentechnik, d. h. durch die optimierten Materialien, den spezifischen Leiterplattenaufbau mit angepasster Dimensionierung der Leiterbahnbreiten, der Leiterbahnabstände, der multifunktionalen Endoberfläche, der Schichtdicken der Dielektrika, die optimierte Auswahl der Durchmesser der Vias 16, 17, 18 und der für diese erforderlichen Bohrungen sowie durch das robuste Design zusammen mit der Verwendung der Leiterplatten-Basismaterialien ist ein spezifischer Aufbau von integrierten Getriebesteuerungen mit mehrlagigen, insbesondere HDI-Leiterplattenlösungen für extreme Anforderungen, realisierbar.

### Bezugszeichenliste

1 Steuereinheit
2 Gehäuse
3 Kühlkörper
4 Leiterplatte
5 erste Wärmeleitkleberschicht
6 aktives elektrisches Bauteil
7 passives elektrisches Bauteil
8 zweite Wärmeleitkleberschicht
9 Bonddraht
10 Bonddraht
11 Bonddraht
12 Stanzgitter
13 Leiterfolie
14 Leiterfolie
15 Vergussmaterial
16 Via, erstes Blind Via
   Wand
17 Via, zweites Blind Via
   Wand
18 Via, Buried Via
18.1 Wand
19 Wärmeleitschicht
20 Wärmeleitschicht
21 Wärmeleitschicht
22 Wärmeleitschicht
23 Wärmeleitschicht
24 Wärmeleitschicht
25 Bonddraht

## Patentansprüche

1. HDI (High-Density-Interconnect)-Leiterplatte (4) mit mehreren übereinander angeordneten Leiterplattenlagen in einer Steuereinheit (1) zur Getriebesteuerung für ein Fahrzeug, wobei die Leiterplattenlagen jeweils aus einem elektrisch isolierenden Basismaterial aus glasfaserverstärktem Kunststoff gebildet sind und mehrere in einer z-Richtung (z) senkrecht zu den Leiterplattenlagen verlaufende Vias (16, 17, 18) vorgesehen sind,
**dadurch gekennzeichnet, dass**
der glasfaserverstärkte Kunststoff eine Beimengung von Keramikpartikeln als Füllstoff aufweist, dessen Glasübergangstemperatur größer oder gleich 170°C ist und der eine
hohe Zyklenbeständigkeit von mehr als 2000 Zyklen zwischen -40 °C und +150 °C
und ferner eine niedrige thermische Ausdehnung in z-Richtung von 30 ppm/K bis 40 ppm/K aufweist, und dass jede Leiterplattenlage eine auf das elektrisch isolierende Basismaterial aufgebrachte Wärmeleitschicht (19 bis 24) aufweist und die Vias (16, 17, 18) die Wärmeleitschichten verschiedener Leiterplattenlagen derart verbinden, dass die Vias (16, 17, 18) und die Wärmeleitschichten (19 bis 24) der Leiterplattenlagen eine Wärmeleitbrücke von einer obersten Leiterplattenlage zu einer untersten Leiterplattenlage bilden, wobei Oberflächen der Wärmeleitschichten unterhalb der obersten Wärmleitschicht größer sind als die Oberfläche der obersten Wärmeleitschicht, und dass die Leiterplatte (4) Leiterbahnen mit Leiterbahnbreiten von mindestens 100 µm aufweist.

2. HDI-Leiterplatte (4) nach Anspruch 1 ,
**dadurch gekennzeichnet, dass** einige Vias (16) erste Blind Vias sind, die wenigstens eine Wärmeleitschicht (19) der obersten Leiterplattenlage mit wenigstens einer Wärmeleitschicht (20 bis 24) einer darunter liegenden Leiterplattenlage verbinden und/oder
dass einige Vias (17) zweite Blind Vias sind, die wenigstens eine Wärmeleitschicht der untersten Leiterplattenlage (24) mit wenigstens einer Wärmeleitschicht (19 bis 23) einer darüber liegenden Leiterplattenlage verbinden und/oder dass einige Vias (18) Buried Vias sind, die jeweils Wärmeleitschichten (19 bis 24) wenigstens zweier verschiedener Leiterplattenlagen verbinden.

3. HDI-Leiterplatte (4) nach Anspruch 2 ,
**dadurch gekennzeichnet, dass** die ersten Blind Vias (16) und/oder die zweiten Blind Vias (17) und/oder die Buried Vias (18) Mikrovias sind.

4. HDI-Leiterplatte (4) nach Anspruch 2 oder 3,
**dadurch gekennzeichnet, dass** in die Leiterplattenlagen in z-Richtung (z) senkrecht zu den Leiterplattenlagen Aussparungen mit einem Durchmesser in einem Bereich zwischen 100 µm und 150 µm zur Aufnahme der ersten Blind Vias (16) und/oder zweiten Blind Vias (17) und Aussparungen mit einem Durchmesser von mindestens 250 µm zur Aufnahme der Buried Vias (18) eingebracht sind.

5. HDI-Leiterplatte (4) nach einem der vorhergehenden Ansprüche,
**dadurch gekennzeichnet, dass** die
Wärmeleitschichten (19 bis 24) der Leiterplattenlagen und/oder
Wände (16.1, 17.1, 18.1) der Vias (16, 17, 18) aus Kupfer gefertigt sind.

6. HDI-Leiterplatte (4) nach Anspruch 5 ,
**dadurch gekennzeichnet, dass** auf die
Wärmeleitschichten (19 bis 24) der Leiterplattenlagen und/oder die Wände (16.1, 17.1, 18.1) der Vias (16, 17, 18) eine multifunktionale Zusatzmetallisierung mit einer Schichtabfolge aus Nickel, Palladium und Gold aufgebracht ist.

7. HDI-Leiterplatte (4) nach einem der vorhergehenden Ansprüche,
**gekennzeichnet durch** wenigstens ein auf der obersten Leiterplattenlage angeordnetes aktives elektrisches Bauteil (6) und/oder durch wenigstens ein auf der obersten Leiterplattenlage angeordnetes passives elektrisches Bauteil (7).

8. HDI-Leiterplatte (4) nach einem der vorhergehenden Ansprüche,
**gekennzeichnet durch** einen Kühlkörper (3), der unter der untersten Leiterplattenlage angeordnet ist, und durch eine erste Wärmeleitkleberschicht (5), die den Kühlkörper (3) stoffschlüssig mit der untersten Leiterplattenlage verbindet, wobei eine maximale Durchbiegung der Leiterplatte (4) kleiner als eine Schichtdicke der ersten Wärmeleitkleberschicht (5) ist.

9. HDI-Leiterplatte (4) nach Anspruch 8 ,
**dadurch gekennzeichnet, dass** die Leiterplatte (4) auf einer dem Kühlkörper (3) abgewandten Seite vollständig von einem Vergussmaterial (15) umgeben ist und das zumindest eine elektrische Bauteil (6, 7) vollständig innerhalb des Vergussmaterials (15) angeordnet ist.

10. Verwendung einer HDI (High-Density-Interconnect)-Leiterplatte (4) nach einem der Ansprüche 1 bis 9, mit mehreren übereinander angeordneten Leiterplattenlagen in einer Steuereinheit (1) zur Getriebesteuerung für ein Fahrzeug, wobei die Leiterplattenlagen jeweils aus einem elektrisch isolierenden Basismaterial aus glasfaserverstärktem Kunststoff gebildet sind und mehrere in einer z-Richtung (z) senkrecht zu den Leiterplattenlagen verlaufende Vias (16, 17, 18) vorgesehen sind,
**dadurch gekennzeichnet, dass**
der glasfaserverstärkte Kunststoff eine Beimengung von Keramikpartikeln als Füllstoff aufweist, dessen Glasübergangstemperatur größer oder gleich 170°C ist und der eine
hohe Zyklenbeständigkeit von mehr als 2000 Zyklen zwischen - 40 °C und +150 °C
und ferner eine niedrige thermische Ausdehnung in z-Richtung von 30 ppm/K bis 40 ppm/K aufweist, und dass jede Leiterplattenlage eine auf das elektrisch isolierende Basismaterial aufgebrachte Wärmeleitschicht (19 bis 24) aufweist und die Vias (16, 17, 18) die Wärmeleitschichten verschiedener Leiterplattenlagen derart verbinden, dass die Vias (16, 17, 18) und die Wärmeleitschichten (19 bis 24) der Leiterplattenlagen eine Wärmeleitbrücke von einer obersten Leiterplattenlage zu einer untersten Leiterplattenlage bilden, wobei Oberflächen der Wärmeleitschichten unterhalb der obersten Wärmleitschicht größer sind als die Oberfläche der obersten Wärmeleitschicht, und dass die Leiterplatte (4) Leiterbahnen mit Leiterbahnbreiten von mindestens 100 µm aufweist.

## Claims

1. HDI (high density interconnect) printed circuit board (4) comprising a plurality of printed circuit board levels arranged one above another in a control unit (1) for transmission control for a vehicle, wherein the printed circuit board levels are formed in each case from an electrically insulating base material composed of glass-fibre-reinforced plastic and a plurality of vias (16, 17, 18) running in a z-direction (z) perpendicular to the printed circuit board levels are provided,
**characterized in that**
the glass-fibre-reinforced plastic has an admixture of ceramic particles as filler, the glass transition temperature of which is greater than or equal to 170°C and which has a high cycle stability of more than 2000 cycles, between -40°C and +150°C and furthermore a low thermal expansion in the z-direction of 30 ppm/K to 40 ppm/K, and **in that** each printed circuit board level comprises a heat-conducting layer (19 to 24) applied to the electrically insulating base material and the vias (16, 17, 18) connect the heat-conducting layers of different printed circuit board levels in such a way that the vias (16, 17, 18) and the heat-conducting layers (19 to 24) of the printed circuit board levels form a heat-conducting bridge from a topmost printed circuit board level to a bottommost printed circuit board level, wherein surface areas of the heat-conducting layers below the topmost heat-conducting layer are greater than the surface area of the topmost heat-conducting layer, and **in that** the printed circuit board (4) comprises conductor tracks having conductor track widths of at least 100 µm.

2. HDI printed circuit board (4) according to Claim 1,
**characterized in that** some vias (16) are first blind vias that connect at least one heat-conducting layer (19) of the topmost printed circuit board level to at least one heat-conducting layer (20 to 24) of an underlying printed circuit board level, and/or **in that** some vias (17) are second blind vias that connect at least one heat-conducting layer of the bottommost printed circuit board level (24) to at least one heat-conducting layer (19 to 23) of an overlying printed circuit board level, and/or **in that** some vias (18) are buried vias that each connect heat-conducting layers (19 to 24) of at least two different printed circuit board levels.

3. HDI printed circuit board (4) according to Claim 2,
**characterized in that** the first blind vias (16) and/or the second blind vias (17) and/or the buried vias (18) are microvias.

4. HDI printed circuit board (4) according to Claim 2 or 3,
**characterized in that** cutouts having a diameter in a range of between 100 µm and 150 µm for accommodating the first blind vias (16) and/or second blind vias (17) and cutouts having a diameter of at least 250 µm for accommodating the buried vias (18) are introduced into the printed circuit board levels in a z-direction (z) perpendicular to the printed circuit board levels.

5. HDI printed circuit board (4) according to any of the preceding claims,
**characterized in that** the heat-conducting layers (19 to 24) of the printed circuit board levels and/or walls (16.1, 17.1, 18.1) of the vias (16, 17, 18) are produced from copper.

6. HDI printed circuit board (4) according to Claim 5,
**characterized in that** a multifunctional additional metallization comprising a layer sequence composed of nickel, palladium and gold is applied to the heat-conducting layers (19 to 24) of the printed circuit board levels and/or the walls (16.1, 17.1, 18.1) of the vias (16, 17, 18).

7. HDI printed circuit board (4) according to any of the preceding claims,
**characterized by** at least one active electrical component (6) arranged on the topmost printed circuit board level and/or by at least one passive electrical component (7) arranged on the topmost printed circuit board level.

8. HDI printed circuit board (4) according to any of the preceding claims,
**characterized by** a heat sink (3) arranged below the bottommost printed circuit board level, and by a first thermally conductive adhesive layer (5), which cohesively connects the heat sink (3) to the bottommost printed circuit board level, wherein a maximum flexure of the printed circuit board (4) is less than a layer thickness of the first thermally conductive adhesive layer (5).

9. HDI printed circuit board (4) according to Claim 8,
**characterized in that** the printed circuit board (4) is completely surrounded by a potting material (15) on a side facing away from the heat sink (3), and the at least one electrical component (6, 7) is arranged completely within the potting material (15).

10. Use of an HDI (high density interconnect) printed circuit board (4) according to any of Claims 1 to 9, comprising a plurality of printed circuit board levels arranged one above another in a control unit (1) for transmission control for a vehicle, wherein the printed circuit board levels are formed in each case from an electrically insulating base material composed of glass-fibre-reinforced plastic and a plurality of vias (16, 17, 18) running in a z-direction (z) perpendicular to the printed circuit board levels are provided,
**characterized in that**
the glass-fibre-reinforced plastic has an admixture of ceramic particles as filler, the glass transition temperature of which is greater than or equal to 170°C and which has a high cycle stability of more than 2000 cycles, between -40°C and +150°C and furthermore a low thermal expansion in the z-direction of 30 ppm/K to 40 ppm/K, and **in that** each printed circuit board level comprises a heat-conducting layer (19 to 24) applied to the electrically insulating base material and the vias (16, 17, 18) connect the heat-conducting layers of different printed circuit board levels in such a way that the vias (16, 17, 18) and the heat-conducting layers (19 to 24) of the printed circuit board levels form a heat-conducting bridge from a topmost printed circuit board level to a bottommost printed circuit board level, wherein surface areas of the heat-conducting layers below the topmost heat-conducting layer are greater than the surface area of the topmost heat-conducting layer, and **in that** the printed circuit board (4) comprises conductor tracks having conductor track widths of at least 100 µm.

## Revendications

1. Circuit imprimé HDI (High Density Interconnect) (4), comprenant plusieurs strates de circuit imprimé disposées les unes au-dessus des autres dans une unité de commande (1) servant à commander la boîte de vitesses pour un véhicule, les strates de circuit imprimé étant respectivement constituées d'un matériau de base électriquement isolant en matière plastique renforcée de fibres de verre et plusieurs trous d'interconnexion (16, 17, 18) qui s'étendent dans une direction Z (z) perpendiculaire aux strates de circuit imprimé étant présents ;
**caractérisé en ce que**
la matière plastique renforcée de fibres de verre possède une adjonction de particules de céramique en tant que charge de remplissage, dont la température de vitrification est égale ou supérieure à 170 °C et qui possède une résistance cyclique élevée de plus de 2000 cycles entre -40 °C et +150 °C et en outre une faible dilatation thermique dans la direction Z de 30 ppm/K à 40 ppm/K,
et **en ce que** chaque strate de circuit imprimé possède une couche thermoconductrice (19 à 24) appliquée sur le matériau de base électriquement isolant et les trous d'interconnexion (16, 17, 18) relient les couches thermoconductrices des différentes strates de circuit imprimé de telle sorte que les trous d'interconnexion (16, 17, 18) et les couches thermoconductrices (19 à 24) des strates de circuit imprimé forment un pont thermoconducteur d'une strate de circuit imprimé la plus en haut à une strate de circuit imprimé la plus en bas, les surfaces des couches thermoconductrices au-dessous de la couche thermoconductrice la plus en haut étant plus grandes que la surface de la couche thermoconductrice la plus en haut, et **en ce que** le circuit imprimé (4) possède des pistes conductrices ayant des largeurs de piste conductrice d'au moins 100 µm.

2. Circuit imprimé HDI (4) selon la revendication 1, **caractérisé en ce que** certains trous d'interconnexion (16) sont des premiers trous d'interconnexion borgnes qui relient au moins une couche thermoconductrice (19) de la strate de circuit imprimé la plus en haut à au moins une couche thermoconductrice (20 à 24) d'une strate de circuit imprimé qui se trouve au-dessous et/ou **en ce que** certains trous d'interconnexion (17) sont des deuxièmes trous d'interconnexion borgnes qui relient au moins une couche thermoconductrice de la strate de circuit imprimé la plus en bas (24) à au moins une couche thermoconductrice (19 à 23) d'une strate de circuit imprimé qui se trouve au-dessus et/ou **en ce que** certains trous d'interconnexion (18) sont des trous d'interconnexion noyés qui relient les couches thermoconductrices (19 à 24) respectives d'au moins deux strates de circuit imprimé différentes.

3. Circuit imprimé HDI (4) selon la revendication 2, **caractérisé en ce que** les premiers trous d'interconnexion borgnes (16) et/ou les deuxièmes trous d'interconnexion borgnes (17) et/ou les trous d'interconnexion noyés (18) sont des microtrous d'interconnexion.

4. Circuit imprimé HDI (4) selon la revendication 2 ou 3, **caractérisé en ce que** des cavités ayant un diamètre dans la plage entre 100 µm et 150 µm, destinées à accueillir les premiers trous d'interconnexion borgnes (16) et/ou les deuxièmes trous d'interconnexion borgnes (17), et des cavités ayant un diamètre minimum de 250 µm, destinées à accueillir les trous d'interconnexion noyés (18), sont incorporées dans les strates de circuit imprimé dans la direction Z (z) perpendiculaire aux strates de circuit imprimé.

5. Circuit imprimé HDI (4) selon l'une des revendications précédentes, **caractérisé en ce que** les couches thermoconductrices (19 à 24) des strates de circuit imprimé et/ou les parois (16.1, 17.1, 18.1) des trous d'interconnexion (16, 17, 18) sont fabriquées en cuivre.

6. Circuit imprimé HDI (4) selon la revendication 5, **caractérisé en ce qu'**une métallisation supplémentaire multifonctionnelle comprenant une séquence de couches en nickel, en palladium ou en or est appliquée sur les couches thermoconductrices (19 à 24) des strates de circuit imprimé et/ou les parois (16.1, 17.1, 18.1) des trous d'interconnexion (16, 17, 18).

7. Circuit imprimé HDI (4) selon l'une des revendications précédentes, **caractérisé par** au moins un composant électrique actif (6) disposé sur la strate de circuit imprimé la plus en haut et/ou par au moins un composant électrique passif (7) disposé sur la strate de circuit imprimé la plus en haut.

8. Circuit imprimé HDI (4) selon l'une des revendications précédentes, **caractérisé par** un dissipateur thermique (3) qui est disposé sous la strate de circuit imprimé la plus en bas, et par une première couche adhésive thermoconductrice (5) qui relie le dissipateur thermique (3) à la strate de circuit imprimé la plus en bas par liaison de matières, une flexion maximale du circuit imprimé (4) étant inférieure à une épaisseur de couche de la première couche adhésive thermoconductrice (5).

9. Circuit imprimé HDI (4) selon la revendication 8, **caractérisé en ce que** le circuit imprimé (4), sur un côté opposé au dissipateur thermique (3), est entièrement entouré d'un matériau de scellement (15) et l'au moins un composant électrique (6, 7) est entièrement disposé à l'intérieur du matériau de scellement (15).

10. Utilisation d'un circuit imprimé HDI (High Density Interconnect) (4) selon l'une des revendications 1 à 9, comprenant plusieurs strates de circuit imprimé disposées les unes au-dessus des autres dans une unité de commande (1) servant à commander la boîte de vitesses pour un véhicule, les strates de circuit imprimé étant respectivement constituées d'un matériau de base électriquement isolant en matière plastique renforcée de fibres de verre et plusieurs trous d'interconnexion (16, 17, 18) qui s'étendent dans une direction Z (z) perpendiculaire aux strates de circuit imprimé étant présents ;
**caractérisée en ce que**
la matière plastique renforcée de fibres de verre possède une adjonction de particules de céramique en tant que charge de remplissage, dont la température de vitrification est égale ou supérieure à 170 °C et qui possède une résistance cyclique élevée de plus de 2000 cycles entre -40 °C et +150 °C et en outre une faible dilatation thermique dans la direction Z de 30 ppm/K à 40 ppm/K,
et **en ce que** chaque strate de circuit imprimé possède une couche thermoconductrice (19 à 24) appliquée sur le matériau de base électriquement isolant et les trous d'interconnexion (16, 17, 18) relient les couches thermoconductrices des différentes strates de circuit imprimé de telle sorte que les trous d'interconnexion (16, 17, 18) et les couches thermoconductrices (19 à 24) des strates de circuit imprimé forment un pont thermoconducteur d'une strate de circuit imprimé la plus en haut à une strate de circuit imprimé la plus en bas, les surfaces des couches thermoconductrices au-dessous de la couche thermoconductrice la plus en haut étant plus grandes que la surface de la couche thermoconductrice la plus en haut, et **en ce que** le circuit imprimé (4) possède des pistes conductrices ayant des largeurs de piste conductrice d'au moins 100 µm.
